Europäisches Patentamt

European Patent Office

Office européen des brevets

(19)

(11) Veröffentlichungsnummer : **0 008 634**
**B1**

(12) **EUROPÄISCHE PATENTSCHRIFT**

(45) Veröffentlichungstag der Patentschrift :
30.03.83

(21) Anmeldenummer : **79102348.4**

(22) Anmeldetag : **09.07.79**

(51) Int. Cl.³ : **C 23 C 13/00, C 23 C 15/00**

(54) **Verfahren zum Auflagern einer Metall- oder Legierungsschicht auf ein elektrisch leitendes Werkstück und Vorrichtung zur Durchführung desselben.**

(30) Priorität : **08.07.78 DE 2830134**

(43) Veröffentlichungstag der Anmeldung :
**19.03.80 Patentblatt 80/06**

(45) Bekanntmachung des Hinweises auf die Patenterteilung : **30.03.83 Patentblatt 83/13**

(84) Benannte Vertragsstaaten :
**AT BE CH FR GB IT LU NL SE**

(56) Entgegenhaltungen :
FR A 1 294 562
FR A 2 084 956
FR A 2 160 390
US A 2 636 855
US A 3 491 015
US A 3 830 721
US A 3 962 988
**IBM TECHNICAL DISCLOSURE BULLETIN,
Vol. 19, Nr. 5, Oktober 1976, P.C. KARR :
« Vacuum deposition of material films on substrates utilizing controlled plasma »**

Die Akte enthält technische Angaben, die nach dem Eingang der Anmeldung eingereicht wurden und die nicht in dieser Patentschrift enthalten sind.

(73) Patentinhaber : **Kieferle, Wolfgang
Lindenstrasse 23
D-7981 Grünkraut (DE)**

**Wäschle, Franz
Brucknerstrasse 16
D-7987 Weingarten (DE)**

(72) Erfinder : **Kieferle, Wolfgang
Lindenstrasse 23
D-7981 Grünkraut (DE)**
Erfinder : **Wäschle, Franz
Brucknerstrasse 16
D-7987 Weingarten (DE)**

# Verfahren zum Auflagern einer Metall- oder Legierungsschicht auf ein elektrisch leitendes Werkstück und Vorrichtung zur Durchführung desselben

Die Erfindung betrifft ein Verfahren zum Auflagern einer Metall- oder Legierungsschicht auf ein elektrisch leitendes Werkstück mittels einer Glimmentladung, wozu das Werkstück als die eine Elektrode eines elektrischen Feldes in einer mit Trägergas beschickten Unterdruckkammer geschaltet ist, wobei das Trägergas und das Spendermedium vor Eintritt in die Unterdruckkammer ionisiert werden und im ionisierten Zustand in das elektrische Feld der Unterdruckkammer überführt werden sowie eine Vorrichtung zur Durchführung desselben.

Bislang wurden zu diesem Zweck die zu beschichtenden Werkstücke in einem galvanischen Bad mit Hilfe von Säuren oder Laugen unterschiedlichen Behandlungszeiten ausgesetzt.

Diese Galvanisierungsverfahren haben den Nachteil, daß sie durch die benötigten Säuren oder Laugen zu einem immer stärker werdenden Umweltproblem werden. Zumindest sind sehr hohe Investitionen erforderlich, um die dabei entstehenden Abwässer zu neutralisieren, sofern nicht hier oder dort die zuständigen Behörden die Einrichtung solcher Anlagen im vorhinein untersagen.

Wegen der hohen Salzfracht der neutralisierten Abwässer entstehen hohe Abwasserabgaben. Allerdings sind auch schon Verfahren bekannt geworden, bei denen das Auflagern einer Metallschicht auf ein elektrisch leitendes Werkstück mittels einer Glimmentladung erfolgt, wozu das Werkstück als die eine Elektrode eines elektrischen Feldes in einer mit Trägergas beschickten Unterdruckkammer geschaltet ist, während die andere Elektrode aus dem Beschichtungsmetall besteht. Diese Verfahren haben sich als nicht sehr geeignet erwiesen, da sie wegen des raschen Verbrauchs der metallabgebenden Elektrode nur die Beschichtung von Drähten oder kleineren Werkstücken und das wegen der geringen Energie der auftreffenden Metallionen nur mit äußerst dünnen und nicht sehr festhaftenden Schichten gestatten.

Aus der US-A-3962988 ist das Verdampfen von auf ein Werkstück aufzutragendem Material durch Erwärmen und Ionisieren des Materials unter Anwesenheit eines inerten Gases in einer Vorkammer bekannt geworden, das in eine Glimmentladungskammer eingeleitet wird (vgl. dort insbesondere Fig. 6). In der US-A-3491015 ist ein Trägerplasmastrom beschrieben, der in einer Lichtbogenvorkammer erzeugt wurde und zur Herstellung von Ionen des Spendermediums im Glimmentladungsraum dient. Weiterhin ist eine Bogenentladungsverdampfung von Spendermedium im Glimmentladungsraum aus der US-A-2636855 bekannt und aus dem IBM-Technical Disclosure Bulletin, Vol. 19, Nr. 5, Okt. 1976, Seite 1518-1520, die Erzeugung von Plasma aus Trägergas und Beschichtungsmaterial mit Hilfe eines Lichtbogens, wobei die Beschichtung nicht in einer Glimmentladungskammer vorgenommen wird.

Der Vollständigkeit halber sei auch das sogenannte Gasplattieren erwähnt, bei dem das aufzulagerne Metall aus einem eine entsprechende Metallverbindung enthaltenden oder aus einer solchen bestehenden Gas auf das Werkstück abgeschieden wird, das aber dazu hocherhitzt werden muß. Derart hohe Temperaturen — es handelt sich dabei um solche von 1 200 °C und darüber — beeinträchtigen die physikalischen Eigenschaften des Werkstükkes, so daß man in der Verwendung des Gasplattierverfahrens sehr beschränkt ist.

Die reine Plasmabeschichtung, mit der jedoch nur dünne Filme erzielbar sind, ist im Handbook of Thin Film Technology, von Meissel/Glang, McGraw-Hill, 1970, beschrieben.

Es stellt sich die Aufgabe, ein Verfahren samt einer Vorrichtung zu schaffen, die die oben genannten Nachteile der bekannten Verfahren dieser Art vermeiden, d. h. umweltfreundlich sind und auch zur Erzeugung dicker Schichten auf größeren Werkstükken geeignet sind, wobei die Erhitzung des Werkstückes auf für dieses schädliche Temperaturen vermieden wird.

Die Lösung wurde in überraschender Weise durch eine Weiterentwicklung der an zweiter Stelle genannten Verfahren gefunden, in dem man eine Bogenentladung zum explosionsartigen Abspattern von Spendermedium unter Zuhilfenahme eines in Turbulenz versetzten Trägergases heranzieht und diese Bogenentladung einer Glimmentladung überlagert und unter Ausnutzung des Kathodenfalls den vor Eintritt in die Unterdruckkammer ionisierten Metallionen des als eine Elektrode geschalteten Spendermediums zusätzlich Energie zuführt, diese Metallionen mit hoher Geschwindigkeit in lauf das als die andere Elektrode geschaltete Werkstück ein- und/oder auflagert.

Dabei kann als die andere Elektrode des elektrischen Feldes ein Flächengebilde aus einer gegen Ionisierung hochwiderstandsfähigen Legierung, und zwar vorzugsweise die Innenwandfläche der Unterdruckkammer verwendet werden. Andererseits können aber auch als zweite oder zusätzliche Elektroden Flächengebilde aus dem Beschichtungsmetall selbst verwendet werden.

Vorteilhafterweise wird bei der Durchführung des Verfahrens so vorgegangen, daß man zuerst das Trägergas in Turbulenz versetzt und bei seinem Weg zur Unterdruckkammer über die Oberfläche des Spendermediums strömen läßt, dort Elektronen ablöst und ionisiert und Ionen des Spendermediums vor Eintritt in die Unterdruckkammer bildet.

Ein Vorteil ist auch, daß man die vom Trägergas abgespatterten Metallionen des Spendermediums durch das Trägergas vor Eintritt in die Unterdruckkammer ionisiert.

Zum Aufbringen einer Legierungsschicht hat es sich als zweckmäßig erwiesen, jeweils Trägergas und die Legierungskomponenten durch den Legierungskomponenten einzeln zugeordnete Ionenerzeuger vorzuionisieren. Eine andere nicht minder zweckmäßige Möglichkeit zum Aufbringen einer Legierungsschicht besteht darin, zusätzliche Elektroden aus unterschiedlichen Beschichtungsmetallen einzusetzen.

Eine Ausführungsvariante sieht vor, daß man weitere, nicht vor Eintritt in die Unterdruckkämmer gebildete, Metallionen des Spendermediums zum Auflagern der Schicht verwendet und die vor Eintritt in die Unterdruckkammer gebildeten Metallionen des Spendermediums zum Auflagern einer Grundschicht nutzt, auf die man danach mindestens eine Schicht auf nicht vor Eintritt in die Unterdruckkammer gebildeten Metallionen des Spendermediums auflagert.

Eine zur Durchführung dieses Verfahrens geeignete Vorrichtung weist einen Ionenerzeuger auf, der aus einem mit dem Trägergas beschickbaren Turbulenzraum, einer Zündkerze zur Bildung eines Lichtbogens im Turbulenzraum und Mitteln für den Kontakt zwischen dem Trägergas und dem Beschichtungsmetall besteht.

Vorzugsweise ist die andere Elektrode des elektrischen Feldes ein Flächengebilde aus einer gegen Ionisierung hochwiderstandsfähigen Legierung, vorzugsweise die Innenwandfläche der Unterdruckkammer.

Eine Ausführungsvariante sieht vor, daß als zweite oder zusätzliche Elektroden Flächengebilde aus dem Spendermedium in der Unterdruckkammer angeordnet sind und zum Aufbringen einer Legierungsschicht jeder Legierungskomponente einzeln ein Ionenerzeuger zugeordnet ist bzw. zum Aufbringen einer Legierungsschicht zusätzliche Elektroden aus unterschiedlichen Spendermedien vorgesehen sind.

Es kann auch vorgesehen sein, daß in die Durchtrittsöffnung vom Turbulenzraum zur Unterdruckkammer ein Lochblech aus Spendermedium eingesetzt ist oder die Wandung des Turbulenzraumes mit einem Futter aus Spendermedium versehen und in die Durchtrittsöffnung zwischen Turbulenzraum und Unterdruckkammer ein siebartig gelochter Napf eingelassen ist, in den das Spendermedium als Granulat eingebracht ist.

Weitere vorteilhafte oder zweckmäßige Ausführungsformen und Einzelheiten der betreffenden Vorrichtung sind den Ansprüchen und der folgenden Einzelbeschreibung zu entnehmen.

Das mit der Erfindung vorgeschlagene Verfahren bringt eine erhebliche Qualitätsverbesserung. Die Metallionen des Beschichtungsmaterials werden sowohl zwischen als auch auf die Elektronen der Oberfläche des Werkstückes aufgetragen.

Die zugehörigen Zeichnungen zeigen beispielhaft in schematischer Darstellung in

Figur 1 eine erfindungsgemäße Vorrichtung im Schnitt

Figur 2 einen Schnitt durch eine Ausführungsform des Ionenerzeugers in größerem

Maßstab,

Figur 3 einen ebensolchen Schnitt durch eine zweite Ausführungsform des Ionenerzeugers,

Figur 4 einen ebensolchen Schnitt durch eine dritte Ausführungsform des Ionenerzeugers,

Figuren 5 und 6 weitere Ausführungsvarianten der Vorrichtung gemäß der Fig. 1.

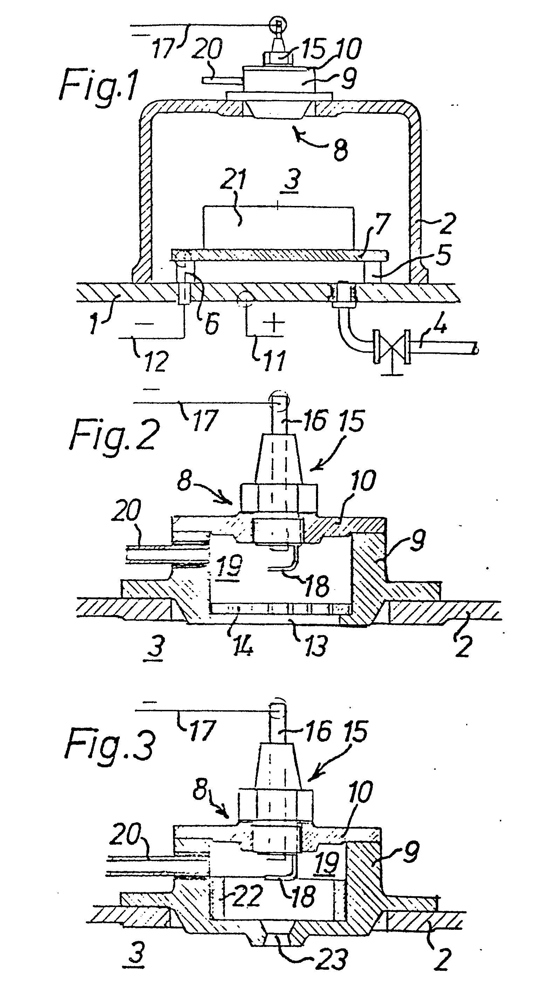

Gemäß Fig. 1 ist auf eine elektrisch leitfähige, isolierte Platte 1 eine Haube 2 zur Bildung der Unterdruckkammer 3 gasdicht aufgesetzt. Eine Rohrleitung 4, die isoliert durch die Platte 1 geführt ist, ist an diese Unterdruckkammer 3 angeschlossen und dient in bekannter Weise zu deren Evakuierung. Auf der Platte 1 wird von Stützisolatoren 5 und 6 die Werkstückauflage 7 getragen. In ihrer Decke besitzt die Haube 2 eine Öffnung, in welche ein Ionenerzeuger 8 eingesetzt ist. Die Platte 1 und mit ihr die Haube 2 sowie das Gehäuse 9 des Ionenerzeugers und dessen Deckel 10 sind durch die Leitung 11 an den positiven Pol einer nicht gezeichneten Stromquelle anschließbar. Die Werkstückauflage 7 ist durch eine Leitung 12, die durch den Stützisolator 6 geführt ist, an den negativen Pol der Stromquelle angeschlossen. Die Platte 1 und die Haube 2, ebenso auch die Werkstückauflage 7 sind aus einem gegenüber einer Ionenauslösung hochwiderstandsfähigen Legierung hergestellt.

Bei dem in Fig. 2 dargestellten Ausführungsbeispiel eines Ionenerzeugers 8 ist im Gehäuse 9 eine zur Unterdruckkammer 3 weisende Öffnung 13 vorgesehen, in die beispielsweise ein Lochblech 14 aus dem Beschichtungsmaterial (Spendermedium) eingesetzt ist. Im Deckel 10 ist z. B. eine Zündkerze 15 eingeschraubt, deren Mittelelektrode 16 durch die Leitung 17 an den negativen Pol der erwähnten Stromquelle angeschlossen ist.

Die Gegenelektrode 18 ist über den Deckel 10, das Gehäuse 9, die Haube 2 und die Platte 1 an den positiven Pol der Stromquelle anschließbar. In dem vom Gehäuse 9 und Deckel 10 umschlossenen Turbulenzraum 19 mündet ein gegenüber dem Gehäuse isolierter Stutzen 20 für die Zuleitung des Trägergases. Es können auch mehrere Stutzen vorgesehen sein und die Einmündung kann radial oder auch tangential gerichtet sein.

Schließlich sind noch hier nicht eigens beschriebene und gezeichnete Mittel bekannter Art zur Regulierung der Spannung und zur Einstellung und Konstanthaltung des Druckes in der Unterdruckkammer je nach den günstigsten Arbeitsbedingungen vorgesehen.

Das mit dem Spendermedium zu beschichtende Werkstück 21 (siehe Fig. 1) wird auf die Werkstückauflage 7 aufgelegt, die Haube 2 auf die Platte 1 aufgesetzt und die so geschlossene Unterdruckkammer 3 durch die Rohrleitung 4 evakuiert. Hernach wird durch den bzw. die Stutzen 20 das Trägergas (z. B. Argon) eingelassen und die Platte 1, die Haube 2 usw. z. B. an die Plusspannung gelegt. Es baut sich somit zwischen Platte 1 und Haube 2 als Anode einerseits und dem Werkstück 21 als Kathode andererseits ein elektrisches Feld auf. Ferner entsteht zwischen der Gegenelektrode 18 und der Mittelelektrode 16 der Zündkerze 15 ein Lichtbogen.

Durch diesen Lichtbogen wird das in den Turbulenzraum 19 eingetretene Trägergas ionisiert und in eine Wirbelströmung versetzt. Die Gasionen dringen durch das Lochblech 14 aus Spendermedium und spattern daraus Metallionen ab, welche als eine Art « Ionenregen » in das elektrische Feld in der Unterdruckkammer 3 gelangen. In diesem werden sie in Richtung des Werkstükkes 21 umgelenkt und treffen dort im Zuge der Glimmentladung zwischen Anode 1, 2 und Kathode 21 mit sehr hoher Geschwindigkeit auf, derart, daß sie zum Teil in die Oberfläche des Werkstückes 21 eindringen und in der Folge eine äußerst festhaftende Metallschicht auf dem Werkstück 21 bilden. Dabei wird die Dicke der Schicht im wesentlichen durch die Zeitdauer des Beschichtungsvorganges bestimmt.

Bezüglich der elektrischen Schaltung konnte auch der Plus-Pol der Stromquelle und die an der Platte 1 angeschlossene Leitung 11 an Erde gelegt werden, wogegen für den Beschichtungsvorgang die Verbindung zwischen Werkstückauflage 7 und Mittelelektrode 16 der Zündkerze 15 mit dem Minuspol der Stromquelle herzustellen wäre. Es sind dann Platte 1 und Haube 2 nicht spannungsführend und es könnte folglich die Isolierung des Durchtritts der Rohrleitung 4 und des Stutzens 20 unterbleiben.

Die Ausführungsform des Ionenerzeugers nach Fig. 3 unterscheidet sich von der nach Fig. 2 nur durch die Anordnung des Spendermediums, das als Ringfutter 22 in das Gehäuse 9 eingelegt ist, und die konturenmäßig etwas andere Ausbildung der zur Unterdruckkammer 3 führenden Öffnung 23.

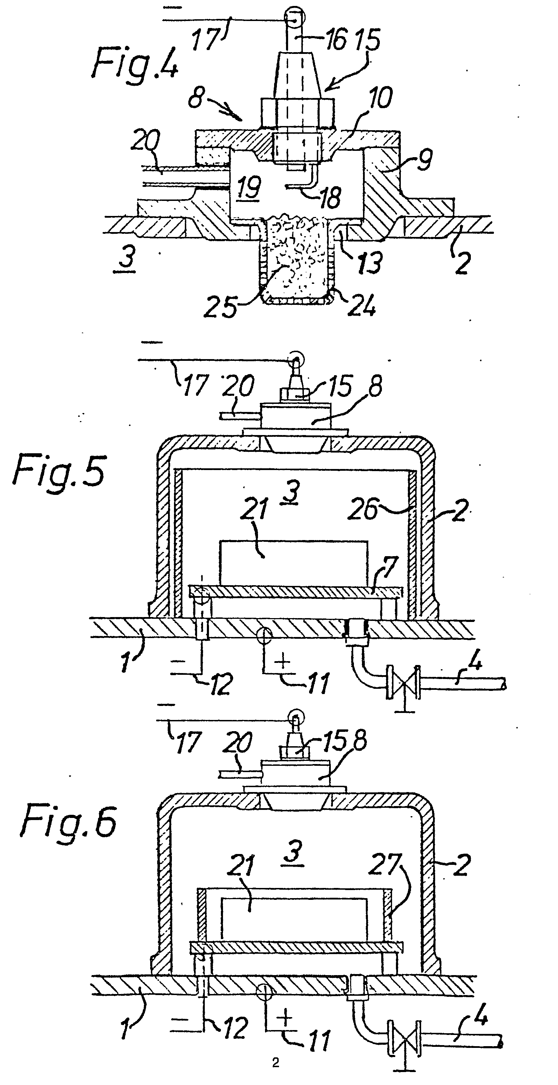

Bei der Ausführungsform nach der Fig. 4 ist in die Übergangsöffnung 13 zur Unterdruckkammer 3 ein siebartig gelochter Napf 24 eingelassen, der das Spendermedium in Form eines Granulats 25 aufnimmt.

Die durch Fig. 5 verdeutlichte Variante der erfindungsgemäßen Vorrichtung bedient sich zusätzlich zum Ionenerzeuger 8 noch einer Anode aus Spendermedium, die hier beispielsweise als Hohlzylinder 26 innerhalb der Haube 2 auf die Platte 1 aufgesetzt ist und das Werkstück 21 umgibt. Bei der weiteren Variante nach Fig. 6 wird eine zusätzliche Kathode aus Spendermedium in Gestalt eines Ringes 27, der das Werkstück 21 umgibt, auf die Werkstückauflage 7 aufgesetzt.

Die Verwendung zusätzlicher Elektroden kann den Zweck haben, den Beschichtungseffekt zu verstärken, besonderes wenn es sich darum handelt, größere Schichtdicken zu erzielen. Es kann aber auch so vorgegangen werden, daß der Ionenerzeuger 8 nur einleitend zur Erzeugung einer ersten festhaftenden Grundschicht verwendet wird, worauf die weitere Beschichtung in herkömmlicher Weise von den zusätzlichen Elektroden 26 bzw. 27 aus erfolgt.

Schließlich können auch mehrere Ionenerzeuger 8 vorgesehen sein, die mit unterschiedlichen Spendermedien ausgestattet sind, um eine legierungsartige Beschichtung des Werkstückes 21 zu erzielen. Das gleiche kann auch erreicht werden, wenn die erwähnten zusätzlichen Elektroden 26 bzw. 27 aus verschiedenen Spendermedien bestehen.

Die Turbulenzen werden beim Erfindungsgegenstand zur Ausnutzung des Kathodenfalls in dem Turbulenzraum 19 direkt unterhalb des Ionenerzeugers 8 gezielt erzeugt, indem das Trägergas, das durch den Stutzen 20 in diesen Turbulenzraum 19 eingeblasen wird, in unmittelbarer Nähe des Ionenerzeugers 8 u. a. durch den zwischen den Elektroden 15 und 18 entstehenden Lichtbogen verwirbelt wird.

Beim Erfindungsgegenstand ist von Vorteil, daß wegen des Kathodenfalls das elektrische Feld überall senkrecht auf der Oberfläche des zu beschichtenden Werkstückes steht, das als Kathode oder Anode geschaltet werden kann. Somit sind im Gegensatz zu den bisher bekannt gewordenen dreidimensionale Beschichtungen möglich.

Der elektrische Fluß wirkt gezielt in Richtung zur Kathode, wo wegen des Kathodenfalls den ionisierten Metallionen noch Energie zugeführt wird, so daß sie auf der Kathode mit hoher Geschwindigkeit auftreffen und eine innige Verbindung mit deren Material eingehen. Beschichtungen, beispielsweise von hochbeanspruchten Lagerflächen mit Schichten von etwa einigen Millimetern und mehr sind somit möglich. Auch Legierungen können damit ein- bzw. auftragen werden.

In Anbetracht der Tatsache, daß es im Vakuum keine auch nur kurzlebige Turbulenzen gibt, muß ein geeigneter sog. Turbulenzraum 19 vorgesehen sein, der in einer determinierten Relation zu dem über den Stutzen 20 eingeblasenen Trägergas, d. h. dessen Strömungsgeschwindigkeit steht.

## Ansprüche

1. Verfahren zum Auflagern einer Metall- oder Legierungsschicht auf ein elektrisch leitendes Werkstück mittels einer Glimmentladung, wozu das Werkstück als die eine Elektrode eines elektrischen Feldes in einer mit Trägergas beschickten Unterdruckkammer geschaltet ist, wobei das Trägergas und das Spendermedium vor Eintritt in die Unterdruckkammer ionisiert werden und im ionisierten Zustand in das elektrische Feld der Unterdruckkammer überführt werden, dadurch gekennzeichnet, daß man eine Bogenentladung zum explosionsartigen Abspattern von Spendermedium unter Zuhilfenahme eines in Turbulenz versetzten Trägergases heranzieht und diese Bogenentladung der Glimmentladung überlagert und unter Ausnutzung des Kathodenfalls den vor Eintritt in die Unterdruckkammen ionisierten Metallionen des als eine Elektrode geschalteten Spendermediums zusätzlich Energie zuführt, diese Metallionen mit hoher Geschwindigkeit inlauf das als die andere Elektrode geschaltete Werkstück ein- und/oder auflagert.

2. Verfahren nach Anspruch 1, dadurch gekennzeichnet, daß man zuerst das Trägergas in Turbulenz versetzt und bei seinem Weg zur Unterdruckkammer über die Oberfläche des Spendermediums strömen läßt, dort Elektronen ablöst und Ionen des Spendermediums vor Eintritt in die Unterdruckkammer bildet.

3. Verfahren nach Anspruch 1 und 2, dadurch gekennzeichnet, daß die vom Trägergas abgespatterten Metallatome des Spendermediums durch das Trägergas vor Eintritt in die Unterdruckkammer ionisiert werden.

4. Verfahren nach Anspruch 1 und 3, dadurch gekennzeichnet, daß man weitere, nicht vor Eintritt in die Unterdruckkammer gebildete Metallionen des Spendermediums zum Auflagern der Schicht verwendet und die vor Eintritt in die Unterdruckkammer gebildeten Metallionen des Spendermediums zum Auflagern einer Grundschicht nutzt, auf die man danach mindestens eine Schicht aus nicht vor Eintritt in die Unterdruckkammer gebildeten Metallionen des Spendermediums auflagert.

5. Vorrichtung zur Durchführung des Verfahrens nach Anspruch 1 bis 4, mit einer Unterdruckkammer (3), Elektroden für die Erzeugung eines elektrischen Feldes in der Unterdruckkammer, einer Evakuiereinrichtung und einem vorgelagerten Ionenerzeuger (8), dadurch gekennzeichnet, daß der Ionenerzeuger (8) aus einem mit Trägergas beschickbaren Turbulenzraum (19), einer Zündkerze (15) zur Bildung eines Lichtbogens im Turbulenzraum (19) und Mitteln (14, 22, 24 und 25) für den Kontakt zwischen dem Trägergas und dem Beschichtungsmetall besteht.

6. Vorrichtung nach Anspruch 5, dadurch gekennzeichnet, daß die andere Elektrode des elektrischen Feldes zur Glimmentladung ein Flächengebilde aus einer gegen Ionisierung hochwiderstandsfähigen Legierung, vorzugsweise die Innenwandfläche der Unterdruckkammer ist.

7. Vorrichtung nach Anspruch 5 und 6, dadurch gekennzeichnet, daß als zweite oder zusätzliche Elektroden Flächengebilde (26, 27) aus dem Spendermedium in der Unterdruckkammer (3) angeordnet sind.

8. Vorrichtung nach Anspruch 5 bis 7, dadurch gekennzeichnet, daß zum Aufbringen einer Legierungsschicht jeder Legierungskomponente einzeln ein Ionenerzeuger (8) zugeordnet ist.

9. Vorrichtung nach Anspruch 5 und einem der folgenden, dadurch gekennzeichnet, daß zum Aufbringen einer Legierungsschicht zusätzliche Elektroden aus unterschiedlichen Spendermedien vorgesehen sind.

10. Vorrichtung nach Anspruch 5 und einem der folgenden, dadurch gekennzeichnet, daß in die Durchtrittsöffnung (13) vom Turbulenzraum (19) zur Unterdruckkammer (3) ein Lochblech (14) aus Spendermedium eingesetzt ist.

11. Vorrichtung nach Anspruch 5 und einem der folgenden, dadurch gekennzeichnet, daß die Wandung des Turbulenzraumes (19) mit einem Futter (22) aus Spendermedium versehen und die Durchtrittsöffnung (23) zur Unterdruckkammer (3) rund ausgebildet ist.

12. Vorrichtung nach Anspruch 5 und einem der folgenden, dadurch gekennzeichnet, daß in die Durchtrittsöffnung (13) zwischen Turbulenzraum (19) und Unterdruckkammer (3) ein siebartig gelochter Napf (24) eingelassen ist, in den das Spendermedium als Granulat (25) eingebracht ist.

**Claims**

1. Method for the deposition of a layer of metal or alloy onto an electrically conducting workpiece by means of a glow discharge, for which the workpiece is connected as the one electrode of an electric field in an underpressure chamber charged with carrier gas, wherein the carrier gas and the donor medium are ionised before entry into the underpressure chamber and are transferred in the ionised state into the electric field of the underpressure chamber, characterised thereby, that one draws on an arc discharge for the explosion-like sputtering of donor medium with the aid of a carrier gas set into turbulence and superimposes this arc discharge on the glow discharge and with utilisation of the cathode drop feeds additional energy before entry into the underpressure chamber to the ionised metal ions of the donor medium connected as one electrode and embeds or deposits these metal ions at high speed in or on the workpiece connected as the other electrode.

2. Method according to claim 1, characterised thereby, that one first sets the carrier gas into turbulence and on its way to the underpressure chamber lets it flow over the surface of the donor medium, there detaches electrons and forms ions of the donor medium before entry into the underpressure chamber.

3. Method according to claim 1 and 2, characterised thereby, that the metal atoms of the donor medium sputtered off by the carrier gas are ionised by the carrier gas before entry into the underpressure chamber.

4. Method according to claim 1 and 3, characterised thereby, that one uses further metal ions of the donor medium not formed before entry into the underpressure chamber for the deposition of the layer and utilises the metal ions of the donor medium formed before entry into the underpressure chamber for the deposition of a base layer, onto which one thereafter deposits at least one layer of metal ions of the donor medium not formed before entry into the underpressure chamber.

5. Apparatus for the performance of the method according to claims 1 to 4, with an underpressure chamber (3), electrodes for the generation of an electric field in the underpressure chamber, an evacuating equipment and an upstream ion generator (8), characterised thereby, that the ion generator (8) consists of a turbulence chamber (19) chargeable with carrier gas, a spark plug (15) for the formation of an electric arc in the turbulence chamber (19) and means (14, 22, 24 and 25) for the contact between the carrier gas and the coating metal.

6. Apparatus according to claim 5, characterised thereby, that the other electrode of the electric field for the glow discharge is a flat structure of an alloy highly resistant to ionisation, preferably the inside wall of the underpressure chamber.

7. Apparatus according to claim 5 and 6, characterised thereby, that flat structures (26, 27) of the donor medium are arranged in the underpressure chamber (3) as second or additional electrodes.

8. Apparatus according to claims 5 to 7, characterised thereby, that an ion generator (8) is individually allocated to each alloy component for the deposition of a layer of alloy.

9. Apparatus according to claim 5 and one of the following ones, characterised thereby, that additional electrodes of different donor media are provided for the deposition of a layer of alloy.

10. Apparatus according to claim 5 and one of the following ones, characterised thereby, that a perforated metal sheet (14) of donor medium is inserted into the passage opening (13) from the turbulence chamber (19) to the underpressure chamber (3).

11. Apparatus according to claim 5 and one of the following ones, characterised thereby, that the wall of the turbulence chamber (19) is provide with a lining (22) of donor medium and the passage opening (13) to the underpressure chamber (3) is roundly shaped.

12. Apparatus according to claim 5 and one of the following ones, characterised thereby, that a pan (24), which is perforated in the manner of a sieve and into which the donor medium is brought as granulate (25), is let into the passage opening (13) between turbulence chamber (19) and underpressure chamber (3).

**Revendications**

1. Procédé pour déposer une couche de métal ou d'alliage sur un objet conducteur de l'électricité au moyen d'une décharge luminescente, dans lequel l'objet joue le rôle d'une électrode d'un champ électrique, disposée dans une chambre remplie d'un gaz porteur en dépression, le gaz porteur et le moyen dispensateur étant ionisés avant leur entrée dans la chambre en dépression et injectés à l'état ionisé dans le champ électrique de la chambre en dépression caractérisé en ce que l'on provoque une décharge d'arc du moyen dispensateur pour effectuer un placage explosif à l'aide du gaz porteur mis en turbulence et en ce que d'une part, l'on superpose la décharge d'arc à la décharge luminescente et d'autre part, en utilisant les ions métalliques du moyen dispensateur constituant l'une des électrodes, ces ions étant ionisés du côté de la cathode avant leur entrée dans la chambre en dépression et fournissant une énergie supplémentaire, l'on plaque ces ions métalliques à grande vitesse dans, et/ou sur l'objet constituant l'autre électrode.

2. Procédé selon la revendication 1 caractérisé en ce que l'on met d'abord le gaz porteur en turbulence et on le laisse s'écouler, au cours de son parcours vers la chambre en dépression, à la surface du moyen dispensateur où l'on enlève les électrons et l'on forme les ions du moyen dispensateur avant l'entrée dans la chambre en dépression.

3. Procédé selon l'une des revendications 1 ou 2 caractérisé en ce que les atomes métalliques du moyen dispensateur plaqués à partir du gaz porteur, sont ionisés par le gaz porteur avant leur entrée dans la chambre en dépression.

4. Procédé selon la revendication 1 ou 3 caractérisé en ce que l'on utilise d'autres ions métalliques du moyen dispensateur pour le dépôt de la couche, ces ions n'étant pas formés avant l'entrée dans la chambre en dépression et en ce que les ions métalliques du moyen dispensateur formés avant l'entrée dans la chambre en dépression servent au dépôt d'une couche de base sur laquelle on dépose ensuite au moins une couche d'ions métalliques du moyen dispensateur, qui ne sont pas formés avant l'entrée dans la chambre en dépression.

5. Dispositif pour la mise en œuvre du procédé selon l'une des revendications 1 à 4 comportant une chambre en dépression (3), des électrodes pour la création d'un champ électrique dans la chambre en dépression, un organe de mise en dépression et un générateur d'ions (8) disposé en amont, caractérisé en ce que le générateur d'ions (8) comporte une chambre de turbulence (19) alimentée en gaz porteur, une bougie d'allumage (15) pour créer un arc dans la chambre de turbulence (19) et des moyens (14, 22, 24 et 25) pour assurer le contact entre le gaz porteur et le métal de recouvrement.

6. Dispositif selon la revendication 5 caractérisé en ce que l'autre électrode du champ électrique pour réaliser la décharge luminescente est un ensemble de surfaces en un alliage à haute résistance à l'ionisation, le cas échéant la surface de paroi intérieure de la chambre en dépression.

7. Dispositif selon la revendication 5 ou 6 caractérisé en ce que des ensembles de surfaces (26, 27) sont disposés comme deuxième électrode ou électrode supplémentaire dans la chambre en dépression (3) hors du moyen dispensateur.

8. Dispositif selon les revendications 5 à 7 caractérisé en ce que, pour appliquer une couche d'alliage, un générateur d'ions (8) est attribué séparément à chaque composant d'alliage.

9. Dispositif selon la revendication 5 et une quelconque des revendications suivantes, caractérisé en ce que, pour appliquer une couche d'alliage, il est prévu des électrodes supplémentaires formées de différents milieux dispensateurs.

10. Dispositif selon la revendication 5 et une quelconque des revendications suivantes, caractérisé en ce qu'une tôle perforée (14) est disposée dans l'ouverture de communication (13) entre la chambre de turbulence (19) et la chambre de dépression (3).

11. Dispositif selon la revendication 5 et une quelconque des revendications suivantes, caractérisé en ce que la paroi de la chambre de turbulence (19) est pourvue d'un revêtement (22) formé du milieu dispensateur, cependant que l'ouverture de communication (23) avec la chambre de dépression (3) présente une forme arrondie.

12. Dispositif selon la revendication 5 et une quelconque des revendications suivantes, caractérisé en ce qu'une cuvette (24) perforée à la manière d'un tamis est disposée dans l'ouverture de communication (13) entre la chambre de turbulence (19) et la chambre de dépression (3), ledit milieu dispensateur étant placé sous forme de granulat (23) dans cette cuvette.

Fig.1

Fig.2

Fig.3

Fig.4

Fig.5

Fig.6